# EUROPEAN PATENT APPLICATION

(11) **EP 4 075 570 A1**
(43) Date of publication of application: **19.10.2022**
(21) Application number: 21842378.8
(22) Date of filing: 08.07.2021
(51) Int. Cl.: H01M 10/48, H01M 10/42, G01B 5/30, G01N 27/04

(54) **BATTERY PACK HAVING IMPROVED SWELLING MEASUREMENT ACCURACY**

(30) Priority: 14.07.2020 KR 20200087035
(71) Applicant: LG Energy Solution, Ltd., Seoul 07335 (KR)
(72) Inventor: SONG, Hyeon-Jin, Daejeon 34122 (KR)
(74) Representative: Hoffmann Eitle
(86) International application number: PCT/KR2021/008750
(87) International publication number: WO 2022/014955

(57) **Abstract**

Disclosed is a battery pack, which may accurately detect swelling of a battery cell according to a situation. The battery pack includes a battery cell having an electrode assembly, an electrolyte, a battery case and an electrode terminal; a deformation measuring unit at least partially attached to an outer surface of the battery case of the battery cell and configured to measure whether the battery case is deformed; an impedance measuring unit connected to the electrode terminal of the battery cell and configured to measure impedance inside the battery cell; and a control unit configured to determine whether the battery cell is swelled by using a deformation measurement result of the deformation measuring unit and an impedance measurement result of the impedance measuring unit.

## Description

### TECHNICAL FIELD

The present application claims priority to Korean Patent Application No. 10-2020-0087035 filed on July 14, 2020 in the Republic of Korea, the disclosures of which are incorporated herein by reference.

The present disclosure relates to a battery technology, and more specifically, to a technology capable of more accurately detecting a swelling situation of a battery cell included in a battery pack.

### BACKGROUND ART

Currently commercialized secondary batteries include nickel cadmium battery, nickel hydrogen battery, nickel zinc battery, lithium secondary battery, and so on. Among these, the lithium secondary battery has almost no memory effect to ensure free charge and discharge, compared to the nickel-based secondary battery, and the lithium secondary battery is spotlighted due to a very low discharge rate and a high energy density.

The lithium secondary battery mainly uses a lithium-based oxides and a carbon material as a positive electrode active material and a negative electrode active material, respectively. The lithium secondary battery includes an electrode assembly in which a positive electrode plate and a negative electrode plate respectively coated with the positive electrode active material and the negative electrode active material are disposed with a separator being interposed therebetween, and an exterior, or a battery case, for hermetically accommodating the electrode assembly together with an electrolyte.

Generally, the lithium secondary batteries may be classified into a can-type secondary battery having an electrode assembly included in a metal can and a pouch-type secondary battery having an electrode assembly included in a pouch of an aluminum laminate sheet, depending on the shape of the exterior.

In relation to such a secondary battery, namely a battery, one of the most important matters is safety. In particular, a swelling phenomenon may occur in the secondary battery as gas or the like is generated during use to inflate the secondary battery. This swelling phenomenon may occur mainly in abnormal situations. If the swelling phenomenon is not detected properly, it may lead to ignition or explosion of the secondary battery, which may cause a big problem.

Although several technologies have been proposed to detect such swelling so far, it is difficult to regard that rapid and accurate swelling detection technology has been completely secured. In particular, in the case of some swelling detection configurations, battery swelling may not be accurately detected due to malfunction or poor contact.

### DISCLOSURE

### Technical Problem

The present disclosure is designed to solve the problems of the related art, and therefore the present disclosure is directed to providing a battery pack, which may accurately detect swelling of a battery cell included therein according to a situation, and a vehicle including the battery pack.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

In one aspect of the present disclosure, there is provided a battery pack, comprising: a battery cell having an electrode assembly, an electrolyte, a battery case and an electrode terminal; a deformation measuring unit at least partially attached to an outer surface of the battery case of the battery cell and configured to measure whether the battery case is deformed; an impedance measuring unit connected to the electrode terminal of the battery cell and configured to measure impedance inside the battery cell; and a control unit configured to determine whether the battery cell is swelled by using a deformation measurement result of the deformation measuring unit and an impedance measurement result of the impedance measuring unit.

Here, the control unit may be configured to determine that the battery cell is not swelled when the impedance measured by the impedance measuring unit is less than a reference impedance, even though the deformation amount measured by the deformation measuring unit is equal to or greater than a reference deformation amount.

In addition, the control unit may be configured to determine whether the impedance increases, when the impedance measured by the impedance measuring unit is less than a reference impedance.

In addition, the control unit may be configured to transmit an impedance measurement start signal to the impedance measuring unit, when the deformation amount measured by the deformation measuring unit is equal to or greater than a reference deformation amount.

In addition, the battery pack may further include a temperature measuring unit located around the battery cell and configured to measure temperature of the battery cell, and the control unit may be configured to determine whether the battery cell is swelled by further considering the temperature measurement result of the temperature measuring unit.

In addition, the control unit may be configured to determine that the battery cell is swelled, only when the deformation amount measured by the deformation measuring unit is equal to or greater than a reference deformation amount, the impedance measured by the impedance measuring unit is equal to or greater than a reference impedance, and the temperature measured by the temperature measuring unit is equal to or greater than a reference temperature.

In addition, the battery cell may be a pouch-type battery that includes an accommodation portion in which the electrode assembly and the electrolyte are accommodates, and a sealing portion disposed around the accommodation portion, the deformation measuring unit may be at least partially attached to the accommodation portion, and the impedance measuring unit may be configured to be at least partially placed on the sealing portion.

In addition, the battery cell may be configured such that the sealing portion is at least partially folded toward the accommodation portion, and the impedance measuring unit may be configured to be at least partially interposed between the accommodation portion and the folded sealing portion of the battery cell.

In addition, the deformation measuring unit may be elongated in one direction to be partially bent, so that one end of the deformation measuring unit is attached onto the printed circuit board and the other end of the deformation measuring unit is attached onto the accommodation portion of the battery cell.

In another aspect of the present disclosure, there is also provided a vehicle, comprising the battery pack according to the present disclosure.

### Advantageous Effects

According to the present disclosure, the swelling situation of a battery cell provided inside the battery pack may be accurately detected.

In particular, according to one aspect of the present disclosure, since deformation and impedance are measured together, it is possible to more accurately determine whether the battery cell is swelled.

Moreover, according to one aspect of the present disclosure, even if a malfunction occurs in a deformation measuring configuration such as a strain gauge, it is possible to verify whether a malfunction occurs by means of the impedance measuring unit.

In addition, according to an embodiment of the present disclosure, by reducing the influence of the magnetic field when measuring the impedance, impedance may be measured more accurately. Therefore, the accuracy of the configuration to detect swelling of the battery cell may be further improved.

Moreover, according to an embodiment of the present disclosure, since the impedance and temperature are measured together and the measurement results are compared with each other, the performance of detecting swelling of the battery cell may be further improved.

In addition, effects of various embodiments according to the present disclosure may be achieved, and some other effects will be described later in each embodiment.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a block diagram schematically showing a functional configuration of a battery pack according to an embodiment of the present disclosure.
FIG. 2 is a diagram schematically showing a connection configuration of the battery pack according to an embodiment of the present disclosure.
FIG. 3 is a circuit diagram schematically showing an impedance measuring unit according to an embodiment of the present disclosure.
FIG. 4 is a perspective view schematically showing the configuration of the battery pack according to an embodiment of the present disclosure.
FIG. 5 is a perspective view schematically showing a configuration of a battery pack according to another embodiment of the present disclosure.
FIG. 6 is a sectional view, taken along the line A1-A1' of FIG. 5.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

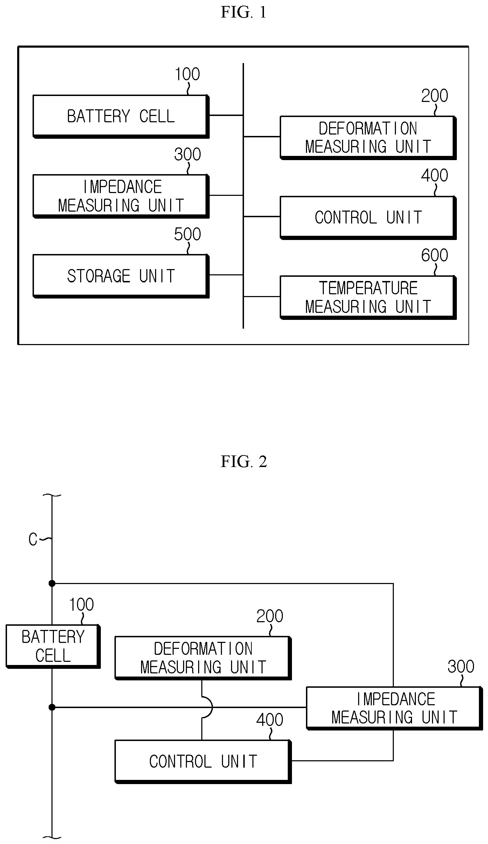

FIG. 1 is a block diagram schematically showing a functional configuration of a battery pack according to an embodiment of the present disclosure. Also, FIG. 2 is a diagram schematically showing a connection configuration of the battery pack according to an embodiment of the present disclosure.

Referring to FIGS. 1 and 2, the battery pack according to the present disclosure may include a battery cell 100, a deformation measuring unit 200, an impedance measuring unit 300, and a control unit 400.

The battery cell 100 is a component that is connected to a charging and discharging path C of the battery pack and may hold and discharge electrical energy by repeatedly performing charging and discharging, and may refer to a single secondary battery. The battery cell 100 may include an electrode assembly, an electrolyte, a battery case and an electrode terminal. Here, the electrode assembly is an assembly of electrodes and a separator, and may be configured such that at least one positive electrode plate and at least one negative electrode plate are disposed with a separator interposed therebetween. In addition, this electrode assembly may be accommodated inside the battery case together with the electrolyte. Also, the electrode terminal may be exposed to the outside of the battery case, and an inner end of the electrode terminal may be electrically connected to the electrode assembly accommodated in the battery case. At least one battery cell 100 may be provided in the battery pack.

The deformation measuring unit 200 may be configured to measure whether the battery cell 100 is deformed. In particular, the deformation measuring unit 200 may be configured to measure whether the appearance of the battery case of the battery cell 100 is changed. To this end, the deformation measuring unit 200 may be configured to measure the displacement of a specific point or part of the battery cell 100.

For example, the deformation measuring unit 200 may be configured to be capable of measuring whether the battery case of the battery cell 100 is at least partially deformed to be convex outward or concave, or whether to be deformed to expand or contract in length, or whether to be deformed to change its position. To this end, the deformation measuring unit 200 may be configured to be at least partially attached to the outer surface of the battery case of the battery cell 100.

The deformation measuring unit 200 may include a strain gauge sensor or may be configured as a strain gauge sensor. The strain gauge sensor is a sensor for measuring deformation with respect to an external force. If the strain gauge sensor is attached to the outer surface of the battery case, it is possible to measure the change of the appearance of the battery case. The strain gauge sensor may be implemented in various forms, like an electric strain gauge sensor that measures a deformation rate by using the change in electric resistance of the strain gauge, and a mechanical strain gauge sensor that measures a deformation rate of a structure by mechanically measuring the change in distance between two points. In the present disclosure, various types of strain gauge sensors known at the time of filing of this application may be employed as the deformation measuring unit 200.

The impedance measuring unit 300 may be configured to measure the impedance inside the battery cell 100. To this end, the impedance measuring unit 300 may be connected to both sides of the electrode terminal of the battery cell 100 and configured to measure the voltage at both ends of the battery cell 100. At this time, the impedance measuring unit 300 may include a voltage sensor. In addition, the impedance measuring unit 300 may include a current sensor to directly measure the current flowing in the battery cell 100. Alternatively, the impedance measuring unit 300 may be configured to receive information about the current flowing in the battery cell 100 from another current sensor or the like provided to the battery pack without directly having a current sensor. In addition, the internal impedance of the battery cell 100 may be measured based on the voltage and current information measured or received as described above. Here, as the impedance of the battery cell 100, the impedance measuring unit 300 may be configured to measure only resistance, which is a real part, or to measure both resistance and reactance.

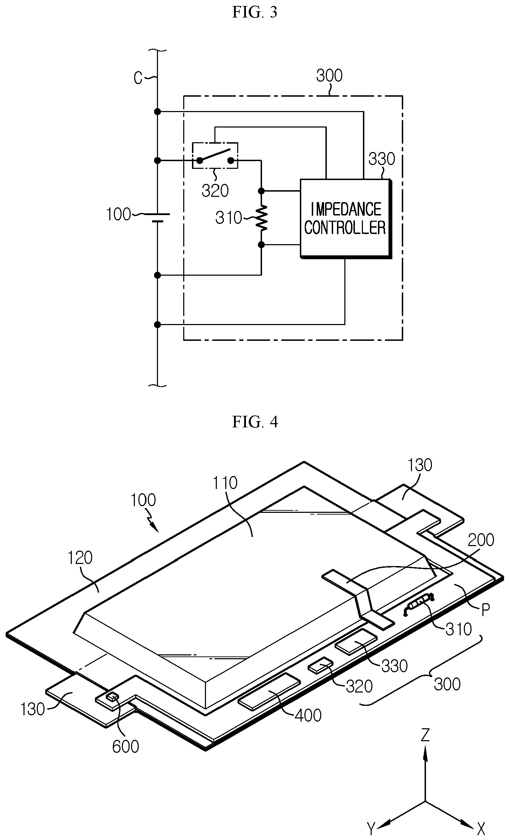

FIG. 3 is a circuit diagram schematically showing the impedance measuring unit 300 according to an embodiment of the present disclosure.

Referring to FIG. 3, the impedance measuring unit 300 may include a resistance element 310 connected to both ends of the battery cell 100. In addition, the switching element 320 may be provided on a connection path between the resistance element 310 and the battery cell 100. Also, the impedance measuring unit 300 may include an impedance controller 330 and configured to turn on and off the switching element 320. Power of the battery cell 100 may be supplied to the resistance element 310 or blocked by turning on/off of the switching element 320. In addition, the impedance controller 330 may be configured to sense the voltage at both ends of the resistance element 310. In addition, the impedance controller 330 may determine the magnitude of the current flowing through the resistance element 310 by sensing the voltage at both ends of the resistance element 310. At this time, the resistance value of the resistance element 310 may be stored in advance in the impedance controller 330 or a storage unit 500. In addition, the magnitude of the current determined in this way may be regarded as being the same as the magnitude of the current flowing through the battery cell 100. Also, the impedance controller 330 may be configured to measure the voltage at both ends of the battery cell 100 when the switching element 320 is turned on so that a current flows to the resistance element 310. In addition, the internal impedance of the battery cell 100 may be measured using the voltage at both ends of the battery cell 100 measured in this way and the determined current of the battery cell 100.

In this embodiment, the impedance controller 330 may be configured to measure the voltage at both ends of the resistance element 310 and the current flowing through the battery cell 100 in a state of maintaining the switching element 320 in the turn-on state. In this case, the impedance measuring unit 300 may be regarded as being configured to measure resistance as the impedance of the battery cell 100 in a state where a DC current flows through the battery cell 100.

In addition, in this embodiment, the impedance controller 330 may be configured to measure the current flowing in the battery cell 100 and the voltage at both ends while repeatedly turning the switching element 320 on and off. In this case, the impedance measuring unit 300 may be regarded as being configured to measure resistance and reactance as the impedance of the battery cell 100 in a state where an AC current flows in the battery cell 100.

According to this embodiment, a separate power supply unit is not required to measure the impedance of the battery cell 100, and the impedance may be measured using the potential of the battery cell 100 itself. Moreover, it is possible to measure the impedance of the battery cell 100 only with a simple element configuration of the switching element 320 and the resistance element 310. In addition, in this embodiment, the impedance of the battery cell 100 may be measured for both the DC situation and the AC situation.

In addition, the impedance measuring unit 300 may be configured to measure the impedance of the battery cell 100 in a situation where the charging or discharging current flows in the charging and discharging path C of the battery cell 100, or to measure the impedance of the battery cell 100 by separately supplying AC or DC power to the battery cell 100. In addition, the impedance measuring unit 300 according to the present disclosure may employ various impedance measuring methods known at the time of filing of this application, for example a 4-terminal pair impedance measurement method.

The control unit 400 may receive the deformation measurement result from the deformation measuring unit 200. In addition, the control unit 400 may receive the impedance measurement result from the impedance measuring unit 300. To this end, the control unit 400 may be connected to the deformation measuring unit 200 and the impedance measuring unit 300 and configured to transmit and receive signals with them. In addition, the control unit 400 may be configured to determine whether the battery cell 100 is swelled by using the deformation measurement result and the impedance measurement result received in this way. That is, the control unit 400 does not determine whether the battery cell 100 is swelled from any one of the deformation measurement result of the deformation measuring unit 200 and the impedance measurement result of the impedance measuring unit 300, but may determine whether the battery cell 100 is swelled by considering the deformation measurement result and the impedance measurement result of the battery cell 100 together.

According to this embodiment configuration of the present disclosure, it is possible to more accurately detect whether the battery cell 100 is swelled. For example, when the swelling of the battery cell 100 is detected by the deformation measuring unit 200 such as a strain gauge sensor, it is possible to verify whether the swelling is actually caused by expansion or deformation of the battery cell 100 or caused by a failure, malfunction, poor contact or connection, or the like of the strain gauge sensor or the like. In particular, when the battery pack is installed to a device such as a vehicle, vibration or shock may be frequently applied to the strain gauge sensor, and thus problems such as malfunction or poor contact of the strain gauge sensor may occur. However, according to the configuration of the present disclosure, since the swelling of the battery cell 100 is verified not only by the deformation measuring unit 200 such as a strain gauge sensor but also by the impedance measuring unit 300, the accuracy may be improved.

Meanwhile, a control element such as the control unit 400 or the impedance controller 330 is well known in the art for executing various control logics performed in the present disclosure, and may optionally include a processor, an application-specific integrated circuit (ASIC), a chipset, a logic circuit, a register, a communication modem, a data processing device and the like. Also, when the control logic is implemented in software, the control unit 400 may be implemented as a set of program modules. In this case, the program module may be stored in a memory and executed by the processor. The memory may be provided inside or outside the processor, and may be connected to the processor by various well-known means. Moreover, the battery pack often includes a control module referred to by terms such as MCU (Micro Controller Unit) or BMS (Battery Management System). The control unit 400 may be at least partially implemented by components such as MCU or BMS generally included in the conventional battery pack.

In particular, the control unit 400 may be configured to compare the deformation amount measured by the deformation measuring unit 200 with a reference deformation amount. Here, the reference deformation amount may be a deformation value serving as a criterion for determining whether the battery cell 100 is deformed or a deformation value that distinguishes each step indicating how much the battery cell 100 is deformed. For example, the reference deformation amount may be a minimum value of the deformation amount in which the battery cell 100 may be determined to swell. In this case, the reference deformation amount may be expressed in the form of a deformation rate or a change rate of the strain gauge. In particular, the reference deformation amount may be expressed as a change rate of the resistance value of the Wheatstone bridge in the case of an electric strain gauge sensor. Alternatively, in the electric strain gauge sensor, the reference deformation amount may be expressed by the resistance value itself.

In addition, the control unit 400 may be configured to compare the impedance measured by the impedance measuring unit 300 with a reference impedance. Here, the reference impedance may be a value serving as a criterion of the internal impedance for determining whether the battery cell 100 is swelled. The reference impedance may be one specific threshold value, or may be in the form of several threshold values having different values. In particular, in the case of several threshold value type, the reference impedances may be threshold values for a plurality of steps indicating how much the battery cell 100 is swelled, respectively. That is, the reference impedance may be a minimum value or a maximum value for determining whether the battery cell 100 swelled or how much the battery cell 100 is swelled. For example, the reference impedance may be an impedance value having a predetermined difference based on the impedance in a normal state of the battery cell 100, such as the BOL (Bottom Of Life) time point of the battery cell 100 or the manufacturing time point of the battery pack.

Meanwhile, the reference deformation amount and the reference impedance to be compared with the measured deformation amount and the impedance measurement value may be stored in advance. In particular, the battery pack according to the present disclosure may include a storage unit 500 as shown in FIG. 1. In this case, the reference deformation amount and the reference impedance may be stored in advance in the storage unit 500.

In addition, in addition to the reference deformation amount and the reference impedance, the storage unit 500 may store a program necessary for at least some components of the battery pack, for example the control unit 400, to perform their function. The storage unit 500 is not particularly limited in its type as long as it is a known information storage means capable of writing, erasing, updating and reading data. For example, the storage unit 500 may be implemented as an information storage means such as RAM (Random Access Memory), SRAM (Static Random Access Memory), flash memory, hard disk, ROM (Read Only Memory), EEPROM (Electrically Erasable Programmable Read Only Memory), registers, SSD (Solid State Disk), SDD (Silicon Disk Drive), and multimedia card micro, or may be configured to include at least one of them.

Preferably, the control unit 400 may be configured to determine whether the deformation amount measured by the deformation measuring unit 200 is equal to or greater than the reference deformation amount. Here, the deformation amount measured by the deformation measuring unit 200 may indicate the degree of deformation compared to any one time point, for example an initial state (BOL) in which the battery cell 100 is not degraded or a time point when the battery pack is manufactured. In addition, the control unit 400 may be configured to determine whether the impedance measured by the impedance measuring unit 300 is greater than or equal to the reference impedance. Also, the control unit 400 may be configured to determine whether the battery cell 100 is swelled by considering both the comparison result between the deformation amount measured by the deformation measuring unit 200 and the reference deformation amount and the comparison result between the impedance measured by the impedance measuring unit 300 and the reference impedance.

Moreover, when the deformation amount measured by the deformation measuring unit 200 is equal to or greater than the reference deformation amount and the impedance measured by the impedance measuring unit 300 is equal to or greater than the reference impedance, the control unit 400 may determine that the battery cell 100 is swelled. Meanwhile, when the impedance measured by the impedance measuring unit 300 is less than the reference impedance, even though the deformation amount measured by the deformation measuring unit 200 is greater than or equal to the reference deformation amount, the control unit 400 may determine that the battery cell 100 is not swelled.

For example, when the reference deformation amount is 1.3 and the reference impedance is 1.0 mO, if the deformation amount measured by the deformation measuring unit 200 is 1.4 and the impedance change amount measured by the impedance measuring unit 300 is 2.0 mΩ, the control unit 400 may determine that the battery cell 100 is swelled. Meanwhile, in a situation where the reference deformation amount and the reference impedance are the same as in this embodiment, if the deformation amount measured by the deformation measuring unit 200 is 1.4 but the impedance change amount measured by the impedance measuring unit 300 is 0.5 mΩ, the control unit 400 may determine that the battery cell 100 is not swelled.

According to this configuration of the present disclosure, in a situation where the swelling of the battery cell 100 is detected by the deformation measuring unit 200, the swelling of the battery cell 100 is verified once again by the impedance measuring unit 300, thereby further improving the detection accuracy for the swelling of the battery cell 100. In particular, in the deformation measuring unit 200 such as a strain gauge sensor, there is a high possibility that errors may occur due to malfunction or poor contact while detecting the change in appearance or the like. However, according to this embodiment, it is possible to determine more accurately whether the swelling of the deformation measuring unit 200 is detected due to an error or is detected normally due to the swelling of the battery cell 100.

In addition, according to the configuration, even if an error does not occur in the deformation measuring unit 200, it is possible to more clearly detect a situation where the battery cell 100 is swelled severely. In relation to this, more specifically, in a situation where the battery cell 100 is swelled severely, the electrical connection structure provided inside the battery cell 100 may be broken.

For example, the battery cell 100 may include a plurality of electrode tabs provided to a plurality of electrode plates and electrode leads connected to the plurality of electrode tabs. If the battery cell 100 is swelled severely, the connection between one or more electrode tabs and the electrode lead may be cut inside the battery cell 100. Alternatively, in the case of a battery cell 100 including a plurality of bi-cells, the electrode tap connecting the bi-cells to each other may be broken. In addition, if some connections between the electrode tabs and the electrode leads or some connections between the electrode tabs are broken, the impedance inside the battery cell may increase. This may be regarded as being similar to a situation where the connection of some resistors among a plurality of resistors connected in parallel is cut. Therefore, when this impedance increases enough to exceed the reference impedance, it may be predicted that the connection of at least some electrode taps is cut inside the battery cell 100. Thus, the control unit 400 may determine whether the battery cell 100 is swelled by considering both the impedance change and the physical displacement change.

Moreover, the control unit 400 may be configured to determine whether the impedance is increased. To this end, the control unit 400 may be configured to compare a currently measured impedance with a previously measured impedance. In particular, the control unit 400 may be configured to determine whether the currently measured impedance has increased compared to the previously measured impedance. Further, the control unit 400 may be configured to determine an impedance change trend, namely whether the impedance is increasing, decreasing, or maintaining a constant state.

For example, if the currently measured impedance is 0.8 mΩ and the previously measured impedance is 0.6 mΩ, the control unit 400 may determine that the impedance tends to increase. Meanwhile, if the previously measured impedance is 0.8 mO, the control unit 400 may determine that the impedance is maintained constant. Further, the control unit 400 may estimate the increase/decrease tendency of the impedance based on three or more impedance measurement results measured at different time points.

In particular, if it is determined that the impedance is increasing, the control unit 400 may determine that the swelling of the battery cell 100 is gradually progressing. This may be presumed to be a result of the number of broken electrode tabs gradually increasing inside the battery cell 100.

Moreover, if the impedance measured by the impedance measuring unit 300 is less than the reference impedance, the control unit 400 may be configured to determine whether the impedance is increasing. In this case, even though it is not determined that the battery cell 100 is swelled or a dangerous situation occurs due to the swelling of the battery cell 100 since the impedance is less than the reference impedance, it may be predicted that the swelling of the battery cell 100 will reach a serious situation in the future. Therefore, according to this embodiment, by predicting the swelling situation of the battery cell 100 in advance, the control unit 400 may take measures to prevent the swelling of the battery cell 100 from becoming more serious or perform a preliminary preparation against the swelling of the battery cell 100. For example, if it is predicted that the swelling situation of the battery cell 100 will arrive, the control unit 400 may be configured to stop or reduce the use of the battery cell 100 or to give a warning to a user such as a vehicle driver through a display unit.

Meanwhile, when the impedance is reduced to a certain level or more compared to the previously measured value, the control unit 400 may determine that this is a temporary error of the impedance measuring unit 300.

In addition, when the impedance measured by the impedance measuring unit 300 is increasing, the control unit 400 may be configured to shorten the measurement cycle of the impedance measuring unit 300 and/or the deformation measuring unit 200. In particular, in a situation where the impedance measured by the impedance measuring unit 300 is less than the reference impedance, if the impedance measured by the impedance measuring unit 300 tends to increase, the control unit 400 may allow the impedance and/or deformation to be measured more often.

For example, if the reference impedance is 1.0 mΩ and the measured impedance is gradually increasing like 0.6 mΩ, 0.7 mΩ, 0.8 mΩ, although the current impedance is still less than the reference impedance, the control unit 400 may be configured to control the impedance measuring unit 300 and/or the deformation measuring unit 200 to shorten the impedance measurement cycle and/or the measurement cycle of the deformation measuring unit 200 from 30 minutes to 20 minutes.

According to this configuration of the present disclosure, in a situation where the swelling of the battery cell 100 is imminent or is gradually progressing, before a final swelling state is determined, the impedance or physical deformation may be measured more frequently, thereby securing more precise swelling detection. In particular, in this embodiment, when a swelling situation occurs in the battery cell 100, the swelling situation may be detected immediately, so that more rapid measures can be taken.

In addition, the control unit 400 may be configured to determine whether the electrode tabs inside the battery cell 100 are broken or how many electrode tabs are broken, based on the impedance measured by the impedance measuring unit 300. To this end, the control unit 400 or the storage unit 500 may include information indicating the number of broken electrode tabs corresponding to the plurality of impedance values.

For example, the control unit 400 or the like may store information of 1, 2, 3, ... as the number of broken electrode taps respectively corresponding to the impedance changes of 1.2 mΩ, 1.4 mΩ, 1.6 mΩ, .... In addition, the control unit 400 may determine how many electrode taps are currently broken in the current battery cell 100 by corresponding the information stored in this way to the impedance value measured by the impedance measuring unit 300.

Moreover, the control unit 400 may be configured to determine whether the swelling of the battery cell 100 becomes more serious based on the number of broken electrode tabs. For example, when it is determined that the number of broken electrode tabs is gradually increased to 2, 3, 4, the control unit 400 may estimate that the swelling of the battery cell 100 becomes more serious. In addition, the control unit 400 may be configured to differentially control charging and discharging of the battery cell 100 according to the degree of swelling of the battery cell 100. For example, when it is determined that one electrode tap is broken, the control unit 400 may maintain charging and discharging of the battery cell 100 and transmit warning information to the user. Meanwhile, when it is determined that two electrode tabs are broken, the control unit 400 may turn off the charging and discharging switch to block charging and discharging of the battery cell 100.

Also, when the deformation amount measured by the deformation measuring unit 200 is equal to or greater than the reference deformation amount, the control unit 400 may be configured to transmit an impedance measurement start signal to the impedance measuring unit 300. That is, the control unit 400 may control the impedance measuring unit 300 to measure the impedance when the deformation amount of the battery cell 100 exceeds a certain level, for example the reference deformation amount.

For example, in a situation where the reference deformation amount is 1.2, if the measured deformation amount is 1.1, the impedance measuring unit 300 may not measure the impedance. However, if the measured deformation amount is greater than or equal to the reference deformation amount, for example 1.3, the control unit 400 may control the impedance measuring unit 300 to measure the impedance of the battery cell 100. In addition, if the impedance measurement value measured by the impedance measuring unit 300 exceeds the reference impedance, it may be determined that the battery cell 100 is swelled.

According to this configuration of the present disclosure, it is possible to prevent resource consumption by the measurement operation of the impedance measuring unit 300. For example, according to the configuration, by reducing the unnecessary impedance measurement operation of the impedance measuring unit 300, it is possible to reduce or omit the consumption of power supplied for impedance measurement or the processing operation performed for impedance measurement.

In addition, the battery pack according to the present disclosure may further include a temperature measuring unit 600 as shown in FIGS. 1 and 2.

The temperature measuring unit 600 may be configured to measure the temperature of the battery cell 100. To this end, the temperature measuring unit 600 may be configured to be located inside the battery pack, particularly around the battery cell 100. For example, the temperature measuring unit 600 may be attached to or located around the electrode terminal or the battery case of the battery cell 100. The temperature measuring unit 600 may be configured to have a temperature sensor, for example a known temperature measuring element such as a thermistor. In addition, various temperature measuring elements known at the time of filing of this application may be employed as a part or all of the temperature measuring unit 600 of the present disclosure.

In this embodiment, the control unit 400 may be configured to further consider the temperature measurement result by the temperature measuring unit 600 when determining whether the battery cell 100 is swelled. That is, the control unit 400 may be configured to determine whether the battery cell 100 is swelled by considering the deformation amount measured by the deformation measuring unit 200, the impedance measured by the impedance measuring unit 300, and the temperature measured by the temperature measuring unit 600 together.

In particular, the control unit 400 may be configured to compare the deformation amount measurement value, the impedance measurement value, and the temperature measurement value with reference values, respectively. That is, the control unit 400 may be configured to compare the deformation amount measured by the deformation measuring unit 200 with the reference deformation amount, compares the impedance measured by the impedance measuring unit 300 with the reference impedance, and compare the temperature measured by the temperature measuring unit 600 with a reference temperature.

Here, the reference temperature may be a value deviating from a temperature range that can be measured in a normal battery cell 100 by a certain level or more. For example, the reference temperature may be a value deviating from the temperature measurement value at the BOL time point of the battery cell 100 by a certain level or more, and may represent a temperature value at which it can be determined that the battery cell 100 is swelled. For example, when the temperature of the battery cell 100 is 20 to 45°C under a normal operating condition of the battery pack, the reference temperature may be set to a value outside this range, for example 50°C.

Moreover, the control unit 400 may be configured to determine that the battery cell 100 is swelled, only when the deformation amount measured by the deformation measuring unit 200 is greater than or equal to the reference deformation amount, the impedance measured by the impedance measuring unit 300 is greater than or equal to the reference impedance, and the temperature measured by the temperature measuring unit 600 is equal to or greater than the reference temperature. That is, the control unit 400 may determines that the battery cell 100 is swelled only when all of the measured deformation amount, the measured impedance, and the measured temperature are equal to or greater than the reference value, and may determine that the battery cell 100 is not swelled if any one of these values is less than the reference value.

For example, in the state where the reference deformation amount is 1.2, the reference impedance is 2.0 mΩ, and the reference temperature is 50°C, even though the measured deformation amount is, for example, 1.3 greater than the reference deformation amount and the measured impedance, for example, 3.0 mΩ greater than the reference impedance, if the measured temperature is 40°C less than the reference temperature, the control unit 400 may be configured to determine that the battery cell 100 is not swelled. Meanwhile, in this embodiment, if the measured deformation amount is 1.3, the measured impedance is 3.0 mΩ, the measured temperature is 55°C, and thus all of these values exceed the reference values, the control unit 400 may be configured to finally determine that the battery cell 100 is swelled.

According to this configuration of the present disclosure, since it is determined whether the battery cell 100 is swelled in consideration of the degree of temperature change along with the degree of deformation and the degree of impedance change of the battery cell 100, it is possible to more accurately determine whether the battery cell 100 is swelled. In particular, as described above, when the battery cell 100 is swelled, some electrode tabs among the plurality of electrode tabs inside the battery cell 100 may be broken. In addition, when the electrode tabs are broken as described above, not only the internal impedance of the battery cell 100 but also the temperature of the battery cell 100 may increase. According to this embodiment of the present disclosure, by measuring whether the temperature of the battery cell 100 changes along with the impedance change, it is possible to more accurately and easily identify the degree of the swelling phenomenon of the battery cell 100.

In addition, the control unit 400 may be configured to determine the swelling situation of the battery cell 100 in stages, based on the deformation amount, impedance and temperature.

For example, if none of the deformation amount, the impedance, and the temperature exceeds the reference value, the control unit 400 may determine that this is a first-stage situation (normal situation). Next, if any one of the deformation amount, the impedance, and the temperature exceeds the reference value, the control unit 400 may determine that this is a second-stage situation (warning situation) distinguished from the first stage. In addition, if two factors among the deformation amount, the impedance, and the temperature exceed the reference value, the control unit 400 may determine that this is a third-stage situation (progressing situation) higher than the second stage. In addition, if three factors among deformation amount, the impedance, and the temperature exceed the reference value, the control unit 400 may determine that this is a fourth-stage situation (dangerous situation) higher than the third stage.

According to this embodiment of the present disclosure, it may be possible to detect and predict more detailed swelling according to the progressing situation of the swelling. Therefore, according to the degree of each swelling, it is possible to take a more suitable measure.

In the battery pack according to the present disclosure, the battery cell 100 may be configured as a pouch-type secondary battery. In addition, the deformation measuring unit 200 and the impedance measuring unit 300 may be configured to be attached to a part of the pouch-type secondary battery. This will be described in more detail with reference to FIG. 4.

FIG. 4 is a perspective view schematically showing the configuration of the battery pack according to an embodiment of the present disclosure.

Referring to FIG. 4, the battery cell 100 may be configured in the form of a pouch-type secondary battery. Such a pouch-type secondary battery is a battery in the form of a laminate sheet in which a metal layer such as aluminum is interposed between polymer layers, and it is widely known at the time of filing of this application. Therefore, the specific configuration of the pouch-type battery will not be described in detail here.

In the case of such a pouch-type battery, the battery cell 100 may include an accommodation portion 110 and a sealing portion 120. Here, the accommodation portion 110 has an empty space therein and may be configured to convexly protrude outward. In addition, in the inner space of the accommodation portion 110, the electrode assembly and the electrolyte may be accommodated. Also, the sealing portion 120 may be arranged around the accommodation portion 110 to surround the accommodation portion 110. In particular, in the pouch-type battery cell 100, the accommodation portion 110 may be formed in a central portion of an upper pouch and/or a lower pouch, and the sealing portion 120 may be formed by sealing an edge portion of the pouches by thermal fusion or the like in a state where the electrode assembly and the electrolyte are accommodated in the accommodation portion 110. Moreover, the sealing portion 120 may be formed entirely in a region surrounding the accommodation portion 110, but may not be formed in a part thereof. For example, the sealing portion 120 may be formed at three side surfaces among the four side surfaces surrounding the accommodation portion 110, and the sealing portion 120 may not be formed at the remaining one side surface. Meanwhile, in the pouch-type battery cell 100, an electrode lead serving as the electrode terminal 130 may be interposed between the pouch case materials and exposed to at least one side. The battery pack according to the present disclosure may employ various kinds of pouch-type batteries known at the time of filing of this application as the battery cell 100.

Meanwhile, although only one battery cell 100 is illustrated in FIG. 4, the battery pack according to the present disclosure may include a plurality of battery cells 100. In this case, at least one of the deformation measuring unit 200 and the impedance measuring unit 300 may be provided to every battery cell 100 in order to measure the deformation amount and the impedance of each battery cell 100. For example, if ten battery cells 100 are included in the battery pack, ten deformation measuring units 200 and ten impedance measuring units 300 may be included to measure the deformation amount and the impedance of the corresponding battery cells 100 separately, for each of ten battery cells 100. In this case, it is possible to accurately measure the deformation amount and the impedance of each of the plurality of battery cells 100.

Moreover, as shown in FIG. 4, the deformation measuring unit 200 may be at least partially attached to the accommodation portion 110 in order to measure the physical deformation of the battery cell 100. When a swelling phenomenon occurs due to gas generation inside the battery cell 100, the accommodation portion 110 may be physically deformed prior to or greater than the sealing portion 120. For example, the deformation measuring unit 200 may be configured in the form of a sheet, as shown in FIG. 4, and may be at least partially attached to the accommodation portion 110 to measure the physical deformation of the accommodation portion 110. In addition, the other part of the deformation measuring unit 200 may be connected to another electrical component, such as a printed circuit board or a wire, in order to transmit the deformation amount measurement information measured by the deformation measuring unit 200 to the control unit 400.

In addition, the impedance measuring unit 300 may be configured to be at least partially placed on the sealing portion 120. In particular, the impedance measuring unit 300 may be provided on a printed circuit board as indicated by P in the drawing, or may be implemented using a printed circuit board P. For example, as shown in FIG. 4, the impedance measuring unit 300 may include a printed circuit board, and may be configured such that a path for impedance measurement is implemented through a conductor pattern formed on the printed circuit board P. In addition, components such as the switching element 320, the resistance element 310, and the impedance controller 330 described above in the embodiment of FIG. 3 may be configured in the form of being mounted on the printed circuit board. In addition, the printed circuit board for implementing the impedance measuring unit 300 may be configured to extend to the electrode terminal 130 (electrode lead) of the battery cell 100, namely the positive electrode lead and the negative electrode lead, to measure the voltage at both ends between the positive electrode lead and the negative electrode lead. In addition, the printed circuit board P forming the impedance measuring unit 300 may be placed on the sealing portion 120. In particular, the printed circuit board P of the impedance measuring unit 300 may be attached to the sealing portion 120.

According to this configuration of the present disclosure, since the impedance measuring unit 300 is configured to be placed on the sealing portion 120 of the battery cell 100, it is possible to reduce the space for the impedance measuring unit 300. Therefore, according to the configuration of the present disclosure, it is possible to prevent the volume of the battery pack from increasing greatly, even though the impedance measuring unit 300 is included. Moreover, when a plurality of secondary batteries are included in the battery pack, the plurality of secondary batteries are often stacked such that the accommodation portions 110 thereof face each other. Even in this configuration, it is possible to prevent the volume of the battery pack from being increased due to the configuration of the impedance measuring unit 300 or the like.

In addition, according to this configuration, since the impedance measuring unit 300 is located adjacent to the battery cell 100, it is possible to reduce the phenomenon that the accuracy of the impedance measurement is lowered due to a magnetic field caused by the current. That is, the magnetic field may be formed due to the current flowing in the battery cell 100 and the current flowing in the impedance measurement path (the path on the resistance element 310 side in FIG. 3) when the impedance is measured. According to this embodiment, the distance between the current flowing through the battery cell 100 and the impedance measurement path may be small. Therefore, the magnetic fields formed by the current flowing in the battery cell 100 and the current flowing in the impedance measurement path may be offset by each other, thereby improving the accuracy of the impedance measurement. In particular, in the embodiment of FIG. 3, an impedance measurement path may be formed to pass through the switching element 320 and the resistance element 310, and the direction of the current flowing through the resistance element 310 may be opposite to the direction of the current flowing through the battery cell 100. In addition, when the distance between the resistance element 310 and the battery cell 100 decreases, the magnetic field offset effect may further increase due to the currents flowing in opposite directions.

Meanwhile, when the impedance measuring unit 300 is configured to include or use the printed circuit board P as in the above embodiment, as shown in FIG. 4, the control unit 400 may also be configured to be mounted on the printed circuit board P. According to this configuration of the present disclosure, it is possible to prevent the volume of the battery pack from increasing greatly due to the control unit 400, and it is also possible to reduce the signal transmission length between the impedance measuring unit 300 and the control unit 400. Accordingly, the accuracy of impedance measurement may be further improved.

In addition, in this embodiment, as shown in FIG. 4, a part of the deformation measuring unit 200 may be connected to the printed circuit board P. Also, the measurement information of the deformation measuring unit 200 may be transmitted to the control unit 400 through the conductor pattern provided on the printed circuit board P. In addition, in this embodiment, the temperature measuring unit 600 may also be mounted on the printed circuit board P. In particular, the temperature measuring unit 600 may be located on a portion of the printed circuit board P in contact with the electrode terminal 130. The temperature of the battery cell 100 may be greatly increased at the electrode terminal 130 side, and the influence by the external temperature may be minimized. In this case, the temperature measurement accuracy can be further improved. Also, according to this embodiment, the distance between the control unit 400 and other components such as the deformation measuring unit 200 or the temperature measuring unit 600 may be reduced. Therefore, it is advantageous for miniaturization of the battery pack, and the influence of noise may be reduced during signal transmission.

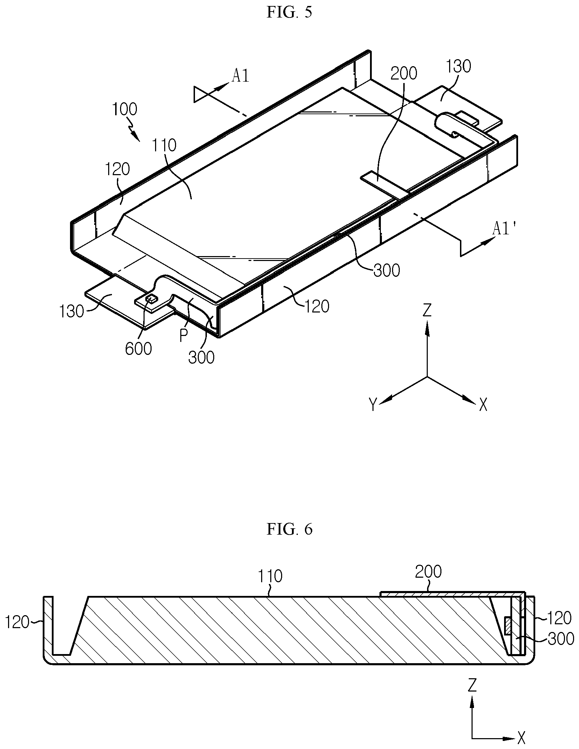

FIG. 5 is a perspective view schematically showing a configuration of a battery pack according to another embodiment of the present disclosure, and FIG. 6 is a sectional view, taken along the line A1-A1' of FIG. 5. However, in the sectional view of FIG. 6, for convenience of explanation, the battery internal configuration such as the electrode assembly is not depicted.

Referring to FIGS. 5 and 6, the battery cell 100 is a pouch-type secondary battery, and may be configured such that the sealing portion 120 is at least partially folded toward the accommodation portion 110. For example, as shown in the figures, among four sealing portions 120 located around the accommodation portion 110, two side sealing portions 120 where the electrode lead is not located may be folded toward the accommodation portion 110. In this configuration, the impedance measuring unit 300 may be configured to be at least partially interposed between the accommodation portion 110 and the folded sealing portion 120 of the battery cell 100. In particular, when the impedance measuring unit 300 is configured in the form of using a printed circuit board, the printed circuit board may be configured to be erected between the accommodation portion 110 and the sealing portion 120 of the battery cell 100.

According to this configuration of the present disclosure, it is possible to further reduce the volume of the battery pack as well as to further reduce the effect of the magnetic field when measuring the impedance. That is, according to the configuration, the impedance measuring unit 300, particularly the impedance measuring path, may be closer to the accommodation portion 110 of the battery cell 100. Therefore, the effect of offsetting the magnetic field is increased, and thus it is possible to more effectively prevent the impedance measurement from being interfered by the magnetic field. In addition, according to this configuration, since the impedance measuring unit 300 is located inside the folded sealing portion 120 of the battery cell 100, it is possible to reduce the effect of the magnetic field formed out of the battery cell 100 on the impedance measuring unit 300 by means of the folded sealing portion 120.

Meanwhile, the deformation measuring unit 200 may be configured in the form of a sheet elongated in one direction. In this case, the deformation measuring unit 200 may be configured such that any part of the central portion thereof is bent. That is, referring to FIG. 6, the deformation measuring unit 200 may include a horizontal portion extending in the left and right direction (x-axis direction) and a vertical portion extending in the vertical direction (z-axis direction). In addition, the vertical portion may be at least partially attached onto the printed circuit board P to be connected to the conductor pattern on the printed circuit board P. In addition, the horizontal portion may be at least partially attached to the accommodation portion 110 of the battery cell 100 to detect deformation of the battery cell 100, particularly swelling of the battery cell 100. In particular, when the deformation measuring unit 200 is configured in the form of an electric strain gauge sensor, most of the resistance line may be located on the horizontal portion.

According to this embodiment of the present disclosure, the volume increase may be minimized while the performance for detecting swelling of the battery cell 100 by the deformation measuring unit 200 is stably secured. In addition, in this case, the signal transmission path of the deformation measuring unit 200 may be minimized.

In addition, when the impedance measuring unit 300 is configured in the form of using the printed circuit board P as in this embodiment, the printed circuit board may be a flexible printed circuit board (FPCB). According to this configuration, since the printed circuit board P may be easily bent according to the shape of the battery cell 100, components such as the impedance measuring unit 300 may be more easily mounted on the battery cell 100. In particular, as shown in FIG. 5, the impedance measuring unit 300 is mostly configured in the form of being erected between the accommodation portion 110 and the sealing portion 120, and the remaining part is desirably configured to be lying in a horizontal direction in order to contact the electrode lead of the battery cell 100. Therefore, the printed circuit board forming the impedance measuring unit 300 is preferably made using an easily bent FPCB so that a part of the impedance measuring unit 300 is in an erected form and the other part is in a lying form.

The battery pack according to the present disclosure may further include various components commonly included in the battery pack in addition to the components described above. For example, the battery pack according to the present disclosure may further include not only a pack case but also various electronic components such as a bus bar, a current sensor, a relay, and a fuse on a charging and discharging path of the battery pack. In addition, the battery pack according to the present disclosure may include a BMS or the like separately for controlling the charging and discharging operation of the battery pack as a whole.

The battery pack according to the present disclosure may be applied to a vehicle such as an electric vehicle or a hybrid electric vehicle. That is, the vehicle according to the present disclosure may include the battery pack according to the present disclosure. The vehicle according to the present disclosure may include well-known components mounted to the vehicle, for example a driving device such as a motor, electric components such as a radio or a navigator, a vehicle body, and a control device such as an ECU (Electronic Control Unit), and the like, in addition to the battery pack according to the present disclosure described above.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

### Reference Signs

100: battery cell
110: accommodation portion, 120: sealing portion, 130: electrode terminal
200: deformation measuring unit
300: impedance measuring unit
310: resistance element, 320: switching element, 330: impedance controller
400: control unit
500: storage unit
600: temperature measuring unit

## Claims

1. A battery pack, comprising:
a battery cell having an electrode assembly, an electrolyte, a battery case and an electrode terminal;
a deformation measuring unit at least partially attached to an outer surface of the battery case of the battery cell and configured to measure whether the battery case is deformed;
an impedance measuring unit connected to the electrode terminal of the battery cell and configured to measure impedance inside the battery cell; and
a control unit configured to determine whether the battery cell is swelled by using a deformation measurement result of the deformation measuring unit and an impedance measurement result of the impedance measuring unit.

2. The battery pack according to claim 1,
wherein the control unit is configured to determine that the battery cell is not swelled when the impedance measured by the impedance measuring unit is less than a reference impedance, even though the deformation amount measured by the deformation measuring unit is equal to or greater than a reference deformation amount.

3. The battery pack according to claim 1,
wherein the control unit is configured to determine whether the impedance increases, when the impedance measured by the impedance measuring unit is less than a reference impedance.

4. The battery pack according to claim 1,
wherein the control unit is configured to transmit an impedance measurement start signal to the impedance measuring unit, when the deformation amount measured by the deformation measuring unit is equal to or greater than a reference deformation amount.

5. The battery pack according to claim 1, further comprising:
a temperature measuring unit located around the battery cell and configured to measure temperature of the battery cell,
wherein the control unit is configured to determine whether the battery cell is swelled by further considering the temperature measurement result of the temperature measuring unit.

6. The battery pack according to claim 5,
wherein the control unit is configured to determine that the battery cell is swelled, only when the deformation amount measured by the deformation measuring unit is equal to or greater than a reference deformation amount, the impedance measured by the impedance measuring unit is equal to or greater than a reference impedance, and the temperature measured by the temperature measuring unit is equal to or greater than a reference temperature.

7. The battery pack according to claim 1,
wherein the battery cell is a pouch-type battery that includes an accommodation portion in which the electrode assembly and the electrolyte are accommodates, and a sealing portion disposed around the accommodation portion,
the deformation measuring unit is at least partially attached to the accommodation portion, and
the impedance measuring unit is configured to be at least partially placed on the sealing portion.

8. The battery pack according to claim 7,
wherein the battery cell is configured such that the sealing portion is at least partially folded toward the accommodation portion, and
the impedance measuring unit is configured to be at least partially interposed between the accommodation portion and the folded sealing portion of the battery cell.

9. The battery pack according to claim 8,
wherein the deformation measuring unit is elongated in one direction to be partially bent, so that one end of the deformation measuring unit is attached onto the printed circuit board and the other end of the deformation measuring unit is attached onto the accommodation portion of the battery cell.

10. A vehicle, comprising the battery pack according to any one of claims 1 to 9.
